# EUROPEAN PATENT APPLICATION

(11) **EP 2 717 314 A1**
(43) Date of publication of application: **09.04.2014**
(21) Application number: 12187107.3
(22) Date of filing: 03.10.2012
(51) Int. Cl.: H01L 29/06, H01L 29/74, H01L 21/332, H01L 21/306

(54) **Method of producing a junction termination for a power semiconductor device and corresponding power semiconductor device**

(71) Applicant: ABB Technology AG, 8050 Zürich (CH)
(72) Inventor: Botan, Virgiliu, 5702 Niederlenz (CH); Vobecky, Jan, 5600 Lenzburg (CH)
(74) Representative: ABB Patent Attorneys

(57) **Abstract**

A method of producing a junction termination (16) for a power semiconductor device, said junction termination (16) being formed as a recess (20) at an edge of a first side of a semiconductor wafer (19) having a first region (12) of a first conductivity type (p) at said first side, said method comprising creating a second region (21) of a second, different conductivity type (n) at said edge of the first side, and removing said second region (21) using an etching fluid, e.g. a KOH solution, which provides a higher etching rate in the second region (21) than in the first region (12), so that the recess (20) is formed. The second region (21) may have a laterally varying doping (VLD) profile to obtain a recess (20) with correspondingly varying depth, e.g. a negative bevel junction termination. With a constant doping profile of the second region (21) a mesa junction termination is achieved.

## Description

The invention relates to a junction termination for a power semiconductor device, wherein said junction termination is formed as a recess at an edge of a first side of a semiconductor wafer, wherein the wafer comprises on the first side a first region of a first conductivity type, which is doped with a first dopant of a first conductivity type. The invention furthermore relates to a power semiconductor device manufactured by using such a method.

In order to achieve high blocking voltages for power semiconductor devices a robust junction termination at a surface edge of the semiconductor wafer is needed. The method used in practice today is the mechanical bevelling of the wafer edge. This process is very tedious, expensive and labor intensive. For example in the case of symmetrical devices like Phase Control Thyristors (PCTs) the bevelling has to be done on both sides of the device; in some cases, in particular for higher voltage devices, even more than once for each side. In such cases, the efforts for creating the junction termination are multiplied.

From V.A.K. Temple et al., "The Theory and Application of a Simple Contour Etch for Near Ideal Breakdown Voltage in Plane and Planar p-n Junctions", IEEE Trans. on Electron Devices, Vol. ED-23, No. 8, August 1976, p. 950-955, a method (Depletion Etch Method, DEM) to increase the breakdown voltage is known where a partial etch is performed in the heavily doped side of the junction of a small region extending beyond the contact and out of the junction termination. The problem of this method is the poor controllability of the etching depth, which results in an unwanted high spread of the breakdown voltage.

In order to overcome the above problem, the same author has presented a method in V.A.K. Temple, "Increased Avalanche Breakdown Voltage and Controlled Surface Electric Fields Using a Junction Termination Extension (JTE) Technique", IEEE Trans. on Electron Devices, Vol. ED-30, No. 8, August 1983, p. 954-957, which uses an ion implementation in order to extend the depletion region by influencing the space charge region. The ion implementation step causes a lot of additional production efforts, leading to an intolerable increase in costs. Furthermore, the JTE method requires subsequent accurate activation of dopants, which is not suited for high-power high-voltage devices where rough surfaces are important for good blocking capability.

The object of the present invention is to provide a method of producing a junction termination with significantly reduced costs, providing reliable control of the etching depth and thus a well-defined high breakdown voltage.

The invention solves this object with the features of the independent claims. By doping a second region on the edge of the first side with a second dopant of a second conductivity type which is different than the first conductivity type, and performing an etching step using an etching fluid which provides a higher etching rate in the second region than in the first region, the etch depth can be accurately controlled because the border between the second dopant and the first dopant provides a well-defined etch stop. The second region is removed so that a corresponding recess is formed. In this manner, the poor controllability of the etch depth in the Depletion Etch Method can be overcome by the invention. The invention effectively provides a reliable etch stop technique over the Depletion Etch Method.

Due to the invention, the laborious, time consuming and costly mechanical bevelling of the wafer edge can advantageously be dispensed with. The suggested method uses photolithographic techniques, in particular etching, instead of grinding for producing the junction termination, thus saving significant costs.

The etching rate in the second region may be higher than in the first region due to a preferred higher doping concentration of the second dopant in the second region than the doping concentration of the first dopant in the first region for the same depths in both regions from the surface to a given depth. It is advantageous if the maximum doping concentration of the second dopant in the second region is at least 10¹⁷ cm⁻³, exemplarily at least 10¹⁸ cm⁻³, exemplarily at least 10¹⁹ cm⁻³, or exemplarily at least 10²⁰ cm⁻³. Alternatively or in addition, the etching rate in the second region may also be higher than in the first region due to the different conductivity type of the first and second regions.

In a preferred embodiment the second dopant is of n-type and the first dopant is of p-type, which makes the invention applicable to the most common types of semiconductor devices using a practically preferred etching solution like a KOH solution, which provides a significantly higher etching rate in n-doped Silicon than in p-doped Silicon.

Advantageously the second region is structured by a photolithographic technique. In one alternative of the invention, the second region can be structured using Variation Lateral Doping (VLD) technique in order to create a laterally varying doping profile in the second region, which makes it possible to generate a desired geometrical profile of the recess. Laterally varying doping profile means that the doping concentration of the second dopant varies in the second region when going, at a constant depth from the wafer surface, from the junction region to the wafer edge. Due to the difference in etching rates, one can obtain, after etching, a geometrical profile which precisely mimics the doping profile in the second region (i.e. the border up to which the second dopant is located in the wafer). This above described method may be called differential etching. In an embodiment of the invention, the second region may be structured with an increasing, exemplarily monotonously increasing or exemplarily linearly increasing doping concentration towards the edge of the wafer in order to generate a recess showing a declining plane towards the wafer edge, i.e., a junction termination with a negative angle.

The invention is by no means limited to Variation Lateral Doping. In another alternative of the invention, for example, a planar doping profile can be formed in the second region, in particular enabling the formation of a so-called mesa junction termination. Planar doping profile means that the doping concentration of the second dopant is essentially constant in the second region when going, at a constant depth from the wafer surface, from the junction region to the wafer edge. Correspondingly, the mesa junction termination has an essentially level bottom surface.

The present invention is applicable to power semiconductor devices, in particular bipolar power semiconductor devices, like thyristors or diodes. A preferred application relates to Phase Control Thyristors (PCTs). However, the invention is also applicable to other discrete devices like Gate Turn-Off thyristors (GTOs), Gate Commutated Turn-off thyristors (GCTs), and the like.

In the following the invention shall be illustrated on the basis of preferred embodiments with reference to the accompanying drawings.
- Fig. 1: shows a schematic cross-sectional view of a Phase Control Thyristor;
- Fig. 2: shows a junction termination with double-negative angle at the edge of a a Phase Control Thyristor;
- Fig. 3: illustrates the formation of a junction termination with a negative bevel angle using Variation Lateral Doping of the second dopant;
- Fig. 4: illustrates the formation of a mesa junction termination using a planar doping profile of the second dopant; and
- Fig. 5: illustrates the formation of another mesa junction termination using a planar doping profile of the second dopant.

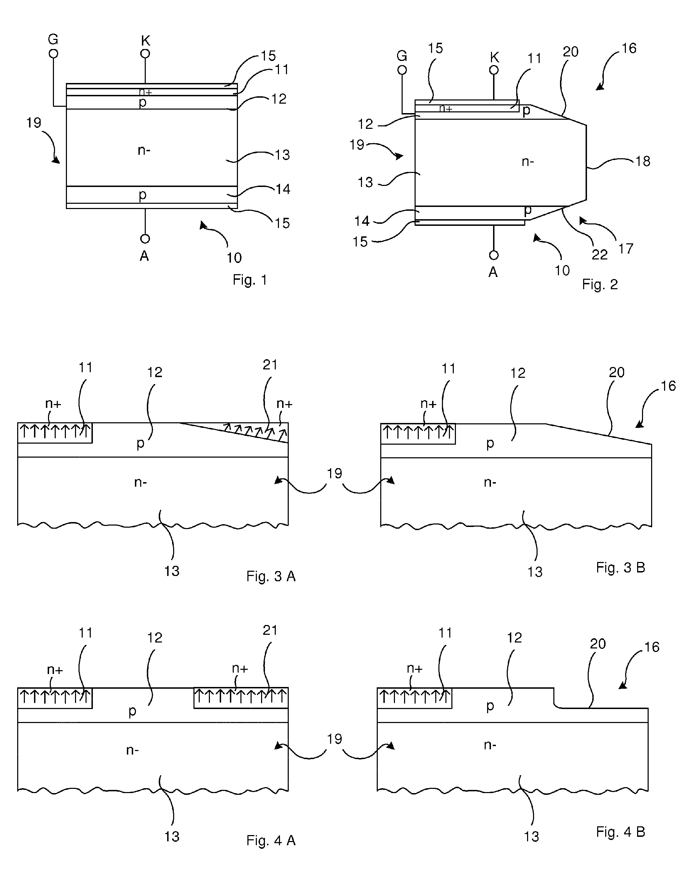

A vertical arrangement of a high-voltage thyristor 10, here a Phase Control Thyristor (PCT), is illustrated in Figure 1. The thyristor 10 comprises a silicon wafer 19, usually with an initial n-type doping. Four alternatively doped layers (pnpn) are integrated, namely a n+ doped cathode emitter 11, a p doped base (p-base) 12, an n- doped n-base 13, and a p doped anode zone 14. Metallizations 15 are provided for the cathode K and anode A terminals.

At the edge of a first side of the thyristor, namely the cathode K side, a first junction termination 16 is formed, and at the second side opposite the first of the thyristor 10, namely the anode A side, a second junction termination 17 is formed in order to avoid premature breakdown of the device 10 caused by a high electrical field in this region as compared with the bulk. The cathode side and the anode side are arranged opposite to each other. These sides form planar surfaces, lateral to which (i.e. on the periphery of the wafer) a junction termination is arranged, in which the thickness of the wafer in a direction perpendicular to the anode or cathode side is reduced. Each junction termination 16, 17 has the form of a geometrical bevel or recess 20, 22 in the wafer 19. Around the edge 18 of the wafer 19 one or more passivation element or passivation layer, usually made of polymer, can be provided, which is not shown Figure 2 for better visibility.

The forming of the junction termination 16 in an embodiment with a declining plane is explained in the following using Figures 3 to 5. Generally, in Figures 3 to 5 the left side denoted (A) and the right side denoted (B) show the wafer 19 before and after etching, respectively.

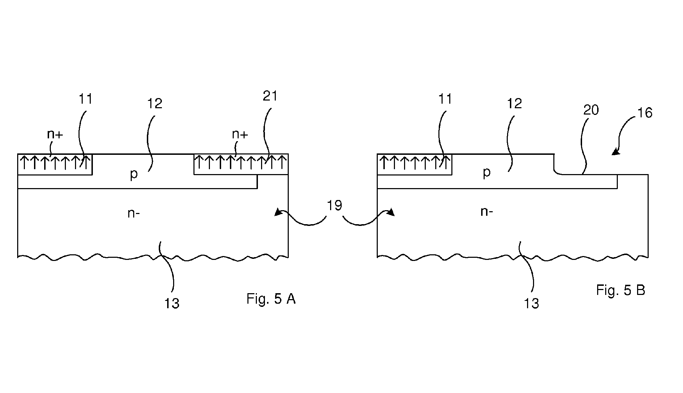

In the first region, here p-base 12, doped with a first dopant of a first conductivity type, here p-type, a second region 21 is formed which is doped with a second dopant of a second conductivity type which is different than the first conductivity type; i.e., here the second conductivity type is n-type. Details of the forming of the second region 21 will be explained below. After the second region 21 has been formed (Figures 3 to 5A), the wafer 19 is etched, i.e. exposed to an etching solution (not shown) at least at the surface of the second region 21 (Figures 3 to 5B). When the first region 12 is created, it may extend to the edge of the wafer (e.g. fig. 4 A) or it may be limited to a central area of the wafer on the first side so that the first region is laterally limited to the central area of the wafer on the first side leaving an area on the periphery (towards the edge) with unamended doping (fig. 5 A). The second region 21 is then created in the first region 12, whereas (like in the case as shown in fig. 5 A), the term "in the first region" shall cover the case that the second region 21 at least overlaps with the first region 12, exemplarily extends beyond the first region 12 in the area towards the edge of the wafer on the first side and extend to the edge.

The etching solution is chosen to provide a significantly higher etching rate in the wafer 19 in the second region 21 than in the first region 12. In particular, for certain wet etching solutions, like a preferred KOH solution, the difference in etching rate between, for example, highly Phosphorous doped silicon in the second region 21 and, for example, Boron doped silicon in the first region 12 can be as high as a thousand times. By the above described etching step the second region 21 is removed while the first region is maintained. Since the border between the second dopant and the first dopant defines a well-defined etch stop, an equally well-defined recess 20 is formed, as shown on the right side of Figures 3 to 5.

Preferably the second region 21 is highly doped with the second dopant, in particular higher than the doping concentration of the first dopant in the first region 12 (for the same depths in both regions 21, 12 from the surface of the first side to a given depth). It is advantageous if the maximum doping concentration of the second dopant in the second region 21 is at least 10¹⁷ cm⁻³, exemplarily at least 10¹⁸ cm⁻³, exemplarily at least 10¹⁹ cm⁻³, or exemplarily at least 10²⁰ cm⁻³.

Generally, the second dopant in the second region 21 is accurately structured (arranged up to a defined depth from the first side) according to the desired geometrical profile of the recess 20. This can be done using photolithographic techniques. In a preferred embodiment, one uses an oxide layer, on top of which a photoresist is deposited. This photoresist is then irradiated through a mask, and then is developed in a developer solution. Next the oxide is etched with the photoresist mask on top of it. Afterwards, all the photoresist is removed. After this step the wafer 19 has on the surface an oxide layer which is identical with the irradiation mask. At this point the wafer is either implanted with the second dopant, or the second dopant is pre-deposited on the wafers surface for diffusing into the wafer 19 to form the second region 21. Here, the oxide layer shields the second dopant, thus achieving a masked profile.

If a recess 20 with a plane declining from the active region to the edge of the wafer is desired, as shown in Figure 2 and Figure 3, right side, the doping concentration of the second dopant should monotonously, exemplarily linearly increase in the second region 21 towards the edge of the wafer. In this manner, a declining border between the first dopant in the first region 12 and the second dopant in the second region 21 is formed, as seen in Figure 3, left side, which functions as an etch stop and leads to the declining recess 20 shown in Figure 3, right side.

The laterally varying doping profile of the second dopant in the second region 21 shown in Figure 3A can be created by Variation Lateral Doping (VLD), in particular using a specially designed photo mask. Laterally varying doping profile means that the doping concentration of the second dopant in the second region 21 varies when going, at a constant depth, from the active or junction region to the wafer edge 18, which can be seen in Figure 3, left side. Exemplarily, in the VLD region, the integral of the doping concentration (and thus the thickness of the second region) in a direction perpendicular to the first side increases with decreasing distance to the edge of the wafer on the first side, so that more material of the wafer is removed towards the edge. In order to get a laterally varying profile of the second dopant, one can use, for example, a photo mask that has openings which vary laterally in density. In the example of Figure 3, left side, the density of openings would increase towards the wafer edge. In this way one achieves a laterally varying concentration of the second dopant. After drive-in of the second dopant, due to lateral diffusion, a smoothly varying, continuous profile emerges. The doping profile is indicated in the Figures 3 to 5 by arrows. The doping concentration of the layer rises towards the arrowhead of the arrow. That means that the doping concentration rises towards the surface of the wafer.

Figures 4 and 5 show embodiments with a so-called mesa structure of the junction termination 16. The mesa junction termination 16 has an essentially flat recess 20, with a level bottom surface, as can be seen on the right side of Figures 4 and 5 so that the recess is arranged parallel to the first side. Such a geometric profile, accompanied by a suited choice of doping profile for the second dopant, can provide the same blocking capability as the standard negative angle bevelling. In order to achieve a mesa junction termination, a planar n+ profile of the second dopant is generated in, for example diffused into, the second region 21. Planar doping profile means that the doping concentration of the second dopant is essentially constant in the second region 21 when going, at a constant depth, from the junction region to the wafer edge 18, which can be seen in Figures 4 and 5, left side. Exemplarily, the doping concentration of the second region 21 is thus constant in a plane parallel to the first side and decreases in a depth direction perpendicular to the first side.

In order to shorten the production process, the recess 20 at the first side and a further recess 22 at an edge of an opposite second side of the semiconductor wafer 19 preferably are created simultaneously, i.e. the doping with the second dopant in a corresponding second regions 21 is created on the second side in the same doping step, and/or the etching of the corresponding second regions 21 is performed in the same etching step so that the creation of the second region and the further second region and/or the etching of the recess or the further recess are performed simultaneously, exemplarily the creation of the regions and the etching is performed simultaneously. The process for the creation of the further recess 22 is the same as for the recess 20 with the only difference that a further second region, which is doped with the second dopant, is created on the edge of the second side instead of on the first side, whereas the etching step is performed on both sides.

For similar reasons, the second region 21 preferably is formed simultaneously with a third region 11 of the same conductivity type. The third region 11 is arranged in the central part of the wafer (active part) on the first side. Exemplarily, for a PCT thyristor, the third region 11 forms the (n+) cathode emitter.

Depending on the semiconductor type to be created, the recess 20 may also be created only on one side of the wafer. The recess 20 surrounds the wafer completely on the first side, and if applicable on the second side, respectively.

In order to protect the third region 11 of the same conductivity type as the second region 21 from being etched in the etching step, a protective layer, for example a Teflon disk, preferably is applied on a central part of the wafer 19 covering said third region 11 after creating the second region 21 and before said etching step. In order to etch more than one wafer 19 at a time, a stack of alternating wafers 19 and protective elements (wafer, disk, wafer, disk, etc.) can be formed. In such a stack arrangement, a protective element has the additional function of separating two wafers 19. When the stack is etched, the central n-layers are protected by the corresponding protective disk.

## Claims

1. Method of producing a junction termination (16) for a power semiconductor device, wherein said junction termination (16) is formed as a recess (20) at an edge of a first side of a semiconductor wafer (19), wherein the wafer (19) comprises on the first side a first region (12) which is doped with a first dopant of a first conductivity type, **characterized by** creating a second region (21) on the edge of the first side, which is doped with a second dopant of a second conductivity type, which is different than the first conductivity type, performing an etching step on said wafer (19) using an etching fluid which provides a higher etching rate in the wafer (19) in the second region (21) than in the first region (12), by which step the second region (21) is removed so that the recess (20) is formed.

2. Method according to claim 1, wherein the etching rate in the second region (21) is higher than in the first region (12) due to at least one of a higher doping concentration in the second region (21) than in the first region (12) and due to the different conductivity type of the first and second regions (12, 21).

3. Method according to anyone of the preceding claims, wherein the maximum doping concentration of the second dopant in the second region (21) is one of at least 10¹⁷ cm⁻³, at least 10¹⁸ cm⁻³, at least 10¹⁹ cm⁻³, or at least 10²⁰ cm⁻³.

4. Method according to anyone of the preceding claims, wherein said second dopant is of n-type and said first dopant is of p-type.

5. Method according to anyone of the preceding claims, wherein said second region (21) is formed simultaneously with a third region (11) in a central part of the wafer (19) having the same conductivity type as the second region (21).

6. Method according to anyone of the preceding claims, wherein after creating said second region (21) and before said etching step a protective layer is applied on a central part of the wafer on the first side.

7. Method according to anyone of the preceding claims, wherein said second region (21) is structured using Variation Lateral Doping VLD.

8. Method according to anyone of the preceding claims, wherein said second region (21) is structured with a doping concentration of said second dopant which increases monotonously, in particular linearly towards the edge of the wafer (19).

9. Method according to anyone of the preceding claims, wherein said second region (21) is formed with a planar profile of the second dopant.

10. Method according to anyone of the preceding claims, wherein said junction termination (16) is formed as a mesa junction.

11. Method according to anyone of the preceding claims, wherein in the formation of said recess (20) any mechanical bevelling step is dispensed with.

12. Method according to anyone of the preceding claims, wherein a further recess (22) at an edge of a second side of a semiconductor wafer (19) opposite said first side is created, wherein for the creation of the further recess (22) a further second region, which is doped with the second dopant, is created on an edge of the second side and an etch step is performed on said wafer (19) using the etching fluid, which provides a higher etching rate in the wafer (19) in the further second region than in the first region (12), by which step the further second region is removed so that the recess (20) is formed..

13. Method according to claim 13, wherein creating the recess (20) and the further recess (22) are created simultaneously.

14. Method according to anyone of the preceding claims, wherein forming a stack of wafers (19), between two of which wafers (19) a protective layer is applied on a central part of each wafer and the recess (20) is formed on the first side of each wafer (19).

15. Power semiconductor device (10), manufactured by using a method according to anyone of the preceding claims.
